# EUROPEAN PATENT APPLICATION

(11) **EP 4 303 598 A2**
(43) Date of publication of application: **10.01.2024**
(21) Application number: 23183990.3
(22) Date of filing: 06.07.2023
(51) Int. Cl.: G01R 31/327, G01R 15/18

(54) **A TEST DEVICE AND A METHOD FOR VERIFYING A PROTECTIVE RELAY OPERATION AT AN ELECTRICAL SUBSTATION AND A ROGOWSKI COIL FOR THE ELECTRICAL SUBSTATION**

(30) Priority: 07.07.2022 FI 20225642
(71) Applicant: P2 Engineering Oy, 28400 Ulvila (FI)
(72) Inventor: Lauri, Pasi, 22400 ULVILA (FI); Tuhkanen, Panu, 28450 ULVILA (FI)
(74) Representative: Koivisto, Harri Kristian

(57) **Abstract**

A test device (10) and a method for verifying a protective relay (20) operation at an electrical substation (100); and a Rogowski coil. The test device (10) is configured to be connected between the protective relay (20) and the at least one low-power voltage sensor (LPVT) or the low-power current sensor (LPCT); and between the protective relay (20) and a switching device (30). In order to measure the operating condition, the device (10) disconnects the at least one low-power voltage sensor (LPVT) or low-power current sensor (LPCT) and the switching device (30) from the protective relay (20); and generates a test signal to the protective relay (20). The remote computer receives information of the operating condition in response to the test signal.

## Description

### BACKGROUND

This disclosure relates to electrical substations, and more particularly to a protective relay testers and current sensors. Protective relays are designed to trip a circuit breaker when a fault is detected. Safety of the power transmission network relies on the correct operation of protective relays, and the protective relays must be tested periodically. The protective relays are located for example at converter substations, transformer substations and switching substations. Protective relays also isolate the faulted portion of the systems and de-energize faulted equipment which helps a power grid or an electrical power transmission network operate with stability.

Geographically the substations may be at locations that are hard to reach. The testing equipment should be transported, often carried to the site. The testing equipment is complicated, often consisting of computers and delicate devices. The testing equipment may be damaged during the transportation. Some components may even be lost during the trip to the substation site. The personnel testing the protective relays must prepare the task with care even for only one protective relay to be tested. The process is meticulous, expensive and time-consuming.

CN106556759B discloses one example of remote-controlled distribution system debugging.

### SUMMARY

This summary is provided to introduce a selection of concepts in a simplified form that are further described below in the detailed description. This summary is not intended to identify key features or essential features of the claimed subject matter, nor is it intended to be used to limit the scope of the claimed subject matter. Furthermore, the claimed subject matter is not limited to implementations that solve any or all disadvantages noted in any part of this disclosure.

A test device and a method for verifying a protective relay operation at an electrical substation, and a Rogowski coil for measuring current at the electrical substation are disclosed hereinafter. The protective relay is tested by a remote controllable test device, a relay tester, that is installed to the electrical substation. In one example the substation is a transformer substation. The test device is suitable for testing protective relays that have separate inputs for low power current sensor and/or low power voltage sensor, and where the protective relay is configured to control a switching device connected to an electrical grid. The test device is installed between said sensors and the protective relay; and also between the protective relay and the switching device. When the test device commences a test sequence, the sensors and the switching device are disconnected from the protective relay. The test sequence does not affect the electrical grid, as the protective relay is temporarily isolated from the electrical grid. The test device provides the required test signals to the protective relay, for example a series of voltages and currents with variable phase differences. The electrical grid may operate during the test sequence as the protective relay is temporarily disconnected.

After the tests have completed, the test device may reconnect the protective relay to the sensors and to the switching device. The test device comprises multiple normally connected (NC) contacts for the sensors and the switching device. The NC contact ensures that the protective relay may still operate to protect the electrical grid, even if the test device malfunctions or its auxiliary power is shut off. The test device is configured to utilize auxiliary direct current from the electrical substation, for example 24 VDC. The test device may receive SCADA (Supervisory Control and Data Acquisition) commands from a remote computer.

The test device is configured to receive information from the Rogowski coil current sensor. The Rogowski coil is configured to interact with the test device. The current angle detection in the test device is modified accordingly, as the Rogowski coil sensor provides current angle with 90 degrees phase difference to a low power current sensor.

The Rogowski coil for the electrical substation current sensor has a shielding made of a metallic mesh. The metallic mesh is cut from a rectangular shape to comprise multiple parallel strips. The mesh is wrapped around the toroid coil by having a first longitudinal edge surround the outer perimeter of the toroid. The opposite, second longitudinal edge has been cut to several strips that extend away from the first longitudinal edge. The strips are wrapped around the toroid to fully cover the toroid. The metallic mesh has strands positioned diagonally in relation to the first longitudinal edge. The diagonal mesh enables wrapping it around the toroid coil more easily.

With the test device, the remote-controlled relay tester, testing of the protective relay is very cost-effective. Tests may be conducted with suitable frequency, at times when the testing itself is scheduled for low risk periods. Even electrical substations located at hard to reach geographical areas may be tested more often, without the risk of increasing testing costs. The test device controls disengaging the voltage/current sensors and the switching device, and after the testing has completed, reconnects the sensors and the switching device to the protective relay. As the process is remote-controlled or scheduled to commence automatically, the risk of human errors in the form of loose connections or damaged contacts is mitigated. The remote-controlled testing procedure also tests the SCADA connection and that all relevant data is received at the supervisory computer.

Many of the attendant features will be more readily appreciated as they become better understood by reference to the following detailed description considered in connection with the accompanying drawings. The embodiments described below are not limited to implementations which solve any or all the disadvantages of known remote-controlled protective relay testing systems or methods.

### BRIEF DESCRIPTION OF THE DRAWINGS

The present description will be better understood from the following detailed description read in light of the accompanying drawings, wherein
FIG. 1 illustrates schematically one exemplary embodiment of a test device at an electrical substation;
FIG. 2 illustrates schematically one exemplary embodiment of a metallic mesh to be used as a shield for a Rogowski coil;
FIG. 3 illustrates schematically one exemplary embodiment of a toroidal coil;
FIG. 4 illustrates schematically a cross-sectional view of the Rogowski coil being shielded;
FIG. 5 illustrates schematically a top view of the Rogowski coil being shielded; and
FIG. 6 illustrates schematically a top view of the shielded Rogowski coil.

Like reference numerals are used to designate like parts in the accompanying drawings.

### DETAILED DESCRIPTION

The detailed description provided below in connection with the appended drawings is intended as a description of the present examples and is not intended to represent the only forms in which the present example may be constructed or utilized. However, the same or equivalent functions and sequences may be accomplished by different examples.

Although the present examples are described and illustrated herein as being implemented in a transformer substation, a test device and the method described are provided as an example and not a limitation. As those skilled in the art will appreciate, the present examples are suitable for application in a variety of remote-controlled electrical substations and electric power system installations.

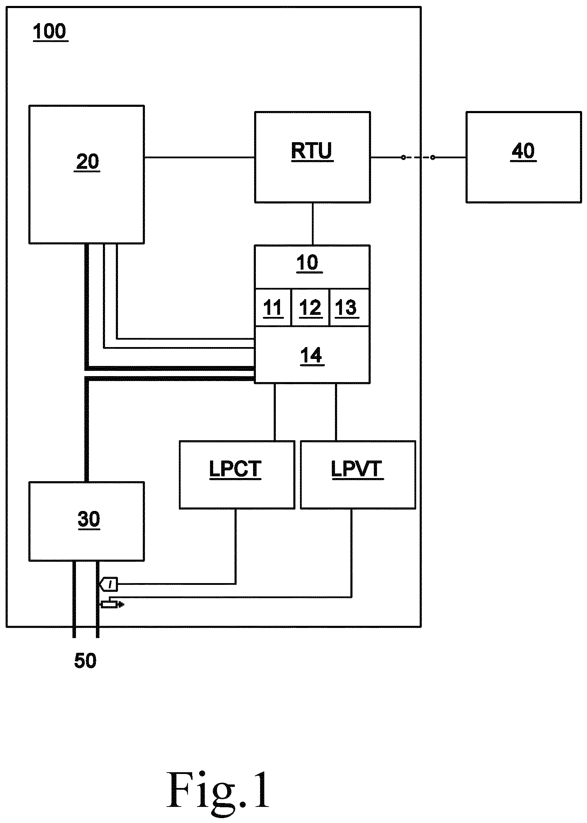

FIG. 1 illustrates schematically one exemplary embodiment of the test device 10 at an electrical substation 100. The electrical substation 100 is in one embodiment an installation at a remote part of an electric power system or an electrical grid 50. An electric power system is a network of electrical components deployed to supply, transfer, and use electric power. An example of a power system is the electrical grid 50 that provides power to homes and industries within an extended area. One example of the electrical grid 50 is an interconnected network for electricity delivery from producers to consumers. The electrical substations 100 are used for transforming the electricity from one voltage to another, removing the effects of parasitic loads or securing the power transmission by protective relays. The electrical substations 100 are often installed at geographically remote locations of the transmission network. Sometimes the electrical substation 100 may be hard to reach by conventional land vehicles. Electrical substations 100 may be used from 120V...230V mains power and up to medium and high voltage power transmission and/or power transform. Electrical substation 100 is in one embodiment a secondary substation or part of a secondary distribution system, a transformer substation or a switching substation - for example a small kiosk type installation at a distant location.

The electrical substation 100 comprises in this embodiment a protective relay 20 that is configured to control a switching device 30 connected to the electrical grid 50. In one embodiment, the protective relay 20 is one example of an intelligent electronic device (IED). The protective relays 20 are switchgear devices that detect a fault and initiate the operation of a switching device 30 to isolate the defective element from the rest of the system. They are compact and self-contained devices which can detect abnormal conditions. The protective relay 20 is connected to the switching device 30 via a contact 14 of the test device 10. The switching device 30 is a circuit breaker, a switch connector, a contact, a switch isolator or a medium voltage network primary circuit device configured to disconnect a portion of the electrical grid 50 as a response from receiving a control signal from the protective relay 20. The protective relay 20 is configured to secure the electrical grid 50 during any malfunction; such as short circuits, ground faults, phase faults or power surges due to power station malfunction or a thunderstorm. The electrical grid 50 may comprise a mesh structure to allow singular connections be isolated from the network, without forming a single point of failure that would halt the operation of the whole network. The protective relay 20 reacts, as a response to signals received from sensors LPCT, LPVT, to any predefined anomaly and disengages the electrical substation 100 from the electrical grid 50 via the switching device 30, and subsequently disconnects a portion of the electrical grid 50.

In this exemplary embodiment, the electrical substation 100 comprises at least one low-power voltage sensor LPVT and at least one low-power current sensor LPCT, that are connected to measure the electrical grid 50. The number of sensors may vary according to the application, purpose of the electrical substation 100, the type of the protective relay 20 or the switching device 30. The low-power voltage sensor LPVT is in one example a Low Power Voltage Transformer, a sensor style voltage transformer having resistive or capacitive dividers. The low-power current sensor LPCT is in one example a Low Power Current Transformer having a direct voltage output.

The test device 10 is configured to verify the correct operation of the protective relay 20. In one embodiment, the test device 10 is a relay tester. The test device comprises at least one processor 11, a memory 12 for storing instructions and a transceiver 13 for communicating with a remote computer 40. The test device 10 executes functions by the processor 11, according to the stored instructions. In one embodiment, the test device 10 is one example of the intelligent electronic device (IED).

In one embodiment, the transceiver 13 is configured to communicate with a remote terminal unit RTU, that is further connected to the remote computer 40. The test device 10 may communicate with the remote terminal unit RTU or, via the remote terminal unit RTU with the remote computer 40. In one embodiment, the remote terminal unit RTU is connected to the protective relay 20. In one embodiment, the test device 10 is configured to interact with the remote computer 40 conforming to a SCADA control system via the remote terminal unit RTU.

SCADA, Supervisory control and data acquisition is a control system architecture comprising computers, networked data communications and graphical user interfaces for high-level supervision of machines and processes. It also covers sensors and other test devices, such as programmable logic controllers, which interface with electric power transmission network. In one embodiment, the remote computer 40 is a SCADA supervisory computer. The remote computer 40 may command the test device 10 to start the testing procedure, or the remote computer may start the testing procedure via the remote terminal unit RTU. In one embodiment, the test device 10 is configured to receive a contact signal from the remote terminal unit RTU and to start measuring the operating condition of the protective relay 20 in response to the contact signal. In one embodiment, the test device 10 is configured to start the testing procedure as a response to a SCADA command received from the remote computer 40. In one embodiment, the test device 10 is configured to start the testing procedure as a response to a command received via the transceiver 13 as a digital signal. In one embodiment, the remote terminal unit RTU is integrated into the test device 10. The functionalities of the remote terminal unit RTU may be executed from the test device 10.

The test device 10 is configured to be connected between the protective relay 20 and the at least one low-power voltage sensor LPVT or the low-power current sensor LPCT by the contact 14, according to the available installed sensors at the electrical substation 100. The contact 14 may comprise multiple separate contacts for predefined purposes.

In order to measure the operating condition, the processor 11 is configured to cause the test device 10 to disconnect the switching device 30 and the at least one low-power voltage sensor LPVT or low-power current sensor LPCT from the protective relay 20. The test device 10 is in one embodiment configured to read the sensor LPVT, LPCT data and verify that the sensor output is within predefined limits. The test device 10 is configured to control the connection between the sensors LPCT, LPVT and the protective relay 20. The test device 10 is configured to control the connection between the switching device 30 and the protective relay 20. The test device 10 is configured to operate on a direct current auxiliary power available at the electrical substation 100, for example 24 VDC. The test device 10 is configured to isolate the protective relay 20 from the electrical grid 50 at least for the duration of the protective relay test.

In one embodiment, the test device 10 comprises a first normally closed (NC) contact 14 for the connection between the protective relay 20 and the at least one low-power voltage sensor LPVT or the low-power current sensor LPCT. In one embodiment, the test device 10 comprises a second normally closed (NC) contact 14 for the connection between the protective relay 20 and the switching device 30. The protective relay 20, the sensors LPVT, LPCT and the switching device 30 are configured to operate even in the situation where the test device 10 is inoperative, out of power or the test device 10 itself malfunctions. Proper functionality of the protective relay 20 is ensured in case the test device 10 would malfunction or its operating power would be down. In one embodiment, the contact 14 comprises multiple relay-type contacts that are controlled by the test device 10 to open for the duration of the testing procedure, and are in the normally closed state when the test device 10 does not actively open the contact.

In one embodiment, the test device 10 is configured to interrupt the test procedure if the SCADA communication with the remote computer 40 is silent for a predetermined time period. In that case, the test device reconnects the sensors LPVT and the switching device 40 to the protective relay 20.

After disconnecting the sensors LPCT, LPVT and the switching device 30, the test device 10 generates at least one test signal to the protective relay 20. In one embodiment, the test device 10 detects the operating condition as a response to the test signal. In one embodiment, the remote computer 40 detects the operating condition as a response to the test signal, for example via SCADA protocol that is delivered to the remote computer 40 via the remote terminal unit RTU.

The operating condition should conform to the expected result of the test signal, leading to either triggering or not triggering the protective relay 20. The test device 10 comprises setup values to be applied within test signals. The setup values should be assigned to follow the installation of the electrical substation 100. Examples of setup values that are in one embodiment adjustable at the test device 10 are: current, voltage, trigger current, trigger voltage, residual voltage, zero potential, residual current, nominal values, trigger signal times, trigger delay and trigger level. The test device 10 setup may take into account tolerances for the protective relay 20 or the environment at the electrical substation 100. As one non-limiting example, the current is set up to 1,1 * nominal trigger current in order to conform with the trigger speed. As another example, the current is set up to 0,9 * nominal trigger current. The values may be tested at different speeds. The setup values may be set up during the first installation when the installer is on site, and may monitor the testing procedure. During the set up phase, the installer selects the most appropriate functions to test the protective relay 20.

The test device 10 may execute multiple test signals to ensure proper operation of the protective relay 20. In one embodiment, the test device 10 emulates the sensor output of the at least one low-power voltage sensor LPVT or the low-power current sensor LPCT, and sends the emulated sensor output as the test signal to the protective relay 20 via the contact 14. In one embodiment, the test device 10 is configured to emulate a signal suitable for the protective relay 20 input that affects the operating condition of the protective relay 20. Exemplary sequence of tests and test signals comprise:

| | |
|---|---|
| I> | Undirected short-circuit at L1; |
| I>> | Undirected short-circuit at L2; |
| I>>> | Directed or undirected short-circuit at L3; |
| Cosϕ lod> | Directed earth fault in resonant earthed neutral system; |
| Sinϕ lod> | Directed earth fault in isolated neutral system. |

As is obvious to a skilled professional, the number of tests and test signals may be defined according to the initial setup during the installation, and later modified. The tests and test signals are stored in the memory 12. The memory may store multiple test procedures having different number of tests or the tests may be run in different orders under various procedures.

In one embodiment, the test device 10 is configured to run a predetermined sequence comprising multiple measurements. The test device 10 runs multiple tests and test signals. In one embodiment, the test device 10 is configured to store into the memory 12 multiple measured operating conditions and to detect a change in the operating conditions when compared to previously stored data. In one embodiment, the test device 10 compares multiple consecutive measurements and is configured to detect an anomaly in the trend of multiple measurements.

In one embodiment, the test device 10 detects the response of the protective relay 20 to each test signal, and defines the operating condition of the protective relay 20. The test device 10 may comprise multiple tests to measure the operating condition. The test device 10 is configured to send the operating condition to the remote computer 40. The operating condition may be a simple status flag. In one embodiment, the operating condition comprises a list of successful tests conducted to the protective relay 20. In one embodiment, the operating condition comprises measurements from the sensors LPCT, LPVT during the testing procedure. In one embodiment, the test device 10 comprises at least one sensor for measuring the test signal. In one embodiment, the remote computer 40 detects the operating condition of the protective relay 20, as the remote computer 40 has information of the test signals and the expected response. In one embodiment, the remote computer 40 sends the test signals, information about the test signals or a test sequence to the test device 10. The test device 10 may store the received information to the memory 12.

In one embodiment, the contact 14 for the low power current sensor LPCT is configured for a Rogowski coil sensor. The test device 10 is configured to receive Rogowski coil sensor data and to emulate the Rogowski coil sensor when providing test signal to the protective relay 20. In one embodiment, the current phase is adjusted 90 degrees when compared to conventional low power current sensor LPCT. In one embodiment the contact 14 for the low power current sensor LPCT is configured to be selectively adapted for a Rogowski coil sensor. The contact 14 may be set up to conform with the sensor type.

The method for verifying, by the test device 10, a protective relay 20 operation at an electrical substation 100 executes the steps as described hereinbefore. During the testing procedure the protective relay 20 is not able to measure the electrical grid 50 or to control the switching device 30. Therefore, the testing may scheduled or selected to be conducted at low-risk periods.

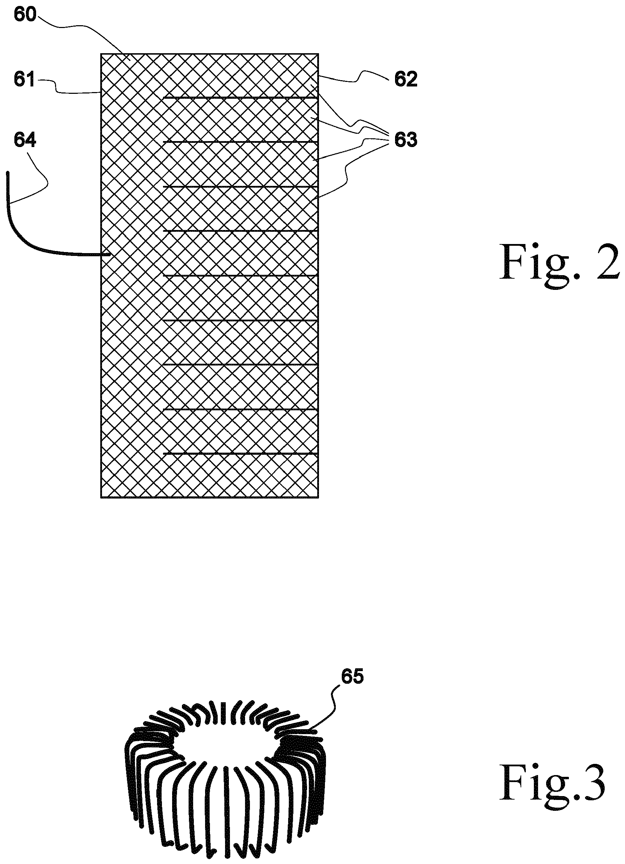

In one embodiment, a Rogowski coil is used for an electrical substation 100 current sensor LPCT. In one embodiment, the Rogowski coil is covered with a mesh of conductive material. FIG. 2 illustrates schematically one exemplary embodiment of the mesh 60 to be used as an electromagnetic shield for the Rogowski coil, before being applied onto the coil. The mesh 60 is made of conductive material, such as metal. In this example, the mesh strands are made of brass having a width of 0,10 mm. The mesh 60 is tight, with up to 100 parallel strands per 1 cm. Various embodiments of mesh 60 with alternative properties may be applied to achieve the shielding effect.

The mesh 60 is in this embodiment rectangular, with a first longitudinal edge 61 and a second longitudinal edge 62. The mesh strands are positioned diagonally to the first longitudinal edge 61. In one exemplary embodiment the strand angle is 45 degrees. The second longitudinal edge 62 is cut towards the first longitudinal edge 61, forming multiple strips 63. As the strands are diagonally in relation to the strips, the strips are easy to bend even sideways. The diagonal placement allows more flexible structure to the strips 63. A grounding wire 64 is connected to the mesh 60.

FIG. 3 illustrates schematically one exemplary embodiment of a toroidal coil 65, comprising a toroid of wire. The toroidal coil 65 is covered with the mesh 60 to provide protection against external disturbances, electromagnetic radiation that could affect the measurement made with the Rogowski coil. The long wire of the coil winding is subject to electric field exposure. An electrostatic shielding is configured to prevent the coil winding from acting as a wideband antenna that could provide noise and affect the sensor measurement. The shielding may act as a Faraday cage that reduces common mode noise on the sensor. In one embodiment, the shielding may act as a low pass filter for high frequency noise, thereby improving electromagnetic compatibility and/or electromagnetic interference compliance for the Rogowski coil sensors.

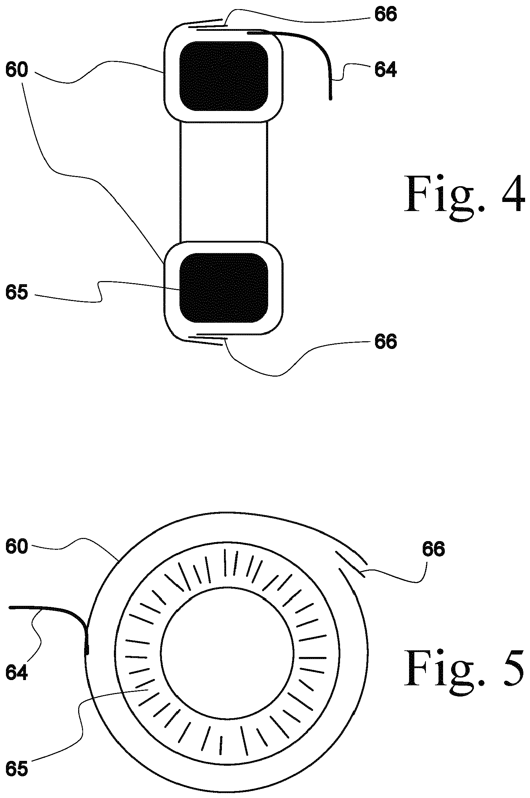

FIG. 4 illustrates schematically a cross-sectional view of the Rogowski coil that is being shielded and FIG. 5 illustrates schematically a top view of the Rogowski coil being shielded. A first longitudinal edge 61 of the mesh 60 is connected to the outer perimeter of the toroid 65. The first longitudinal edge 61 surrounds the outer perimeter completely. The overlapping portions of the first longitudinal edge 61 comprise insulation 66 to prevent galvanic connection. Multiple strips 63 are wrapped around the toroidal coil 65, wherein the overlapping portions of the multiple strips comprise insulation 66 to prevent galvanic connection.

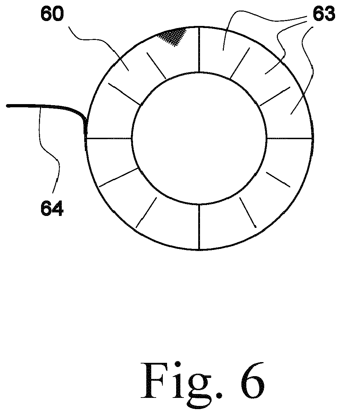

FIG. 6 illustrates schematically a top view of the shielded Rogowski coil, wherein the mesh is positioned diagonally in relation to the strips 60. The strips 63 enable simple method for wrapping the shield around the toroidal coil 65. The shielding mitigates noise and improves the accuracy of the current sensor LPCT, particularly when measuring low currents. Any noise currents or voltages may be grounded with low impedance solution.

A test device for verifying a protective relay operation at an electrical substation is disclosed herein. The protective relay is configured to control a switching device of an electrical grid and to be connected to at least one low-power voltage sensor or to at least one low-power current sensor. The test device comprises: a transceiver for communicating with a remote computer; and at least one processor and a memory storing instructions that, when executed, cause the test device to: measure at least one operating condition of the protective relay; and provide the operating condition to the remote computer. The test device is configured to be connected between the protective relay and the at least one low-power voltage sensor or the low-power current sensor. The test device is configured to be connected between the protective relay and the switching device. The test device is configured to operate on a direct current auxiliary power. In order to measure the operating condition, the processor is configured to cause the test device to: disconnect the switching device and the at least one low-power voltage sensor or low-power current sensor from the protective relay; and generate a test signal to the protective relay; wherein the remote computer receives information of the operating condition in response to the test signal. In one embodiment, the test device comprises a first normally closed contact for the connection between the protective relay and the at least one low-power voltage sensor or the low-power current sensor; and a second normally closed contact for the connection between the protective relay and the switching device. In one embodiment, the test device is configured to interact with the remote computer conforming to a SCADA control system, wherein the test device is connected to the remote computer via a remote terminal unit. In one embodiment, the test device is configured to receive a contact signal from the remote terminal unit and to start measuring the operating condition of the protective relay in response to the contact signal. In one embodiment, the contact for the low power current sensor is configured for a Rogowski coil sensor. In one embodiment, the contact for the low power voltage sensor is configured to be selectively adapted for a Rogowski coil sensor. In one embodiment, the test device is configured to run a predetermined sequence of test signals. In one embodiment, the test device is configured to: detect the operating condition as a response to the test signal; store into the memory multiple detected operating conditions; and detect a change in the operating conditions when compared to previously stored data.

Alternatively, or in addition a method for verifying, by a test device, a protective relay operation at an electrical substation is disclosed herein. In the method the protective relay is controlling a switching device of an electrical grid and is connected to at least one low-power voltage sensor or to at least one low-power current sensor. The method comprises the steps of: detecting at least one operating condition of the protective relay; and providing the operating condition to a remote computer, the test device is executing the steps of: connecting between the protective relay and a switching device of the electrical grid; connecting between the protective relay and the at least one low-power voltage sensor or the low-power current sensor; operating on a direct current auxiliary power; and in order to measure the operating condition: disconnecting the switching device and the at least one low-power voltage sensor or low-power current sensor from the protective relay; generating a test signal to the protective relay; and the remote computer receiving information of the operating condition of the protective relay as a response to the test signal. In one embodiment, the method comprises interacting with the remote computer according to a SCADA control system, wherein the test device is connected to the remote computer via a remote terminal unit. In one embodiment, the method comprises, by the test device, receiving a contact signal from the remote terminal unit and starting measuring the operating condition of the protective relay in response to the contact signal. In one embodiment, the method comprises, by the test device, connecting between the protective relay and the at least one low-power voltage sensor or the low-power current sensor by a first normally closed contact; and connecting between the protective relay and a switching device of the electrical grid by a second normally closed contact. In one embodiment, the method comprises the test device running a predetermined sequence of test signals; and storing into the memory multiple measured operating conditions and detecting a change in the operating conditions when compared to previously stored data.

Alternatively, or in addition, a Rogowski coil for an electrical substation current sensor is disclosed herein. The Rogowski coil comprises a toroidal coil of wire and a shield surrounding the toroidal coil. The shield comprises: an electrically conductive mesh; a first longitudinal edge of the mesh being connected to the outer perimeter of the toroidal coil, surrounding the outer perimeter, wherein the overlapping portions of the first longitudinal edge comprise insulation to prevent galvanic connection; a second longitudinal edge comprises multiple cuts, extending from the second longitudinal edge towards the first longitudinal edge; said multiple cuts forming multiple strips being connected to the first longitudinal edge; multiple strips are wrapped around the toroidal coil, wherein the overlapping portions of the multiple strips comprise insulation to prevent galvanic connection. In one embodiment, the electrically conductive mesh comprises electrically conductive strands in diagonal angle towards the first longitudinal edge.

Alternatively, or in addition, the controlling functionality described herein can be performed, at least in part, by one or more hardware components or hardware logic components. An example of the system described hereinbefore is a computing-based test device comprising one or more processors which may be microprocessors, controllers or any other suitable type of processors for processing computer-executable instructions to control the operation of the test device to edit, display and/or transmit the information or provide connection to other devices. The computer-executable instructions may be provided using any computer-readable media that is accessible by a computing-based device. Computer-readable media may include, for example, computer storage media, such as memory and communications media. Computer storage media, such as memory, includes volatile and non-volatile, removable and non-removable media implemented in any method or technology for storage of information, such as computer-readable instructions, data structures, program modules or other data. Computer storage media includes, but is not limited to, RAM, ROM, EPROM, EEPROM, flash memory or other memory technology, CD-ROM, digital versatile disks (DVD) or other optical storage, magnetic cassettes, magnetic tape, magnetic disk storage or other magnetic storage devices, or any other non-transmission medium that can be used to store information for access by a computing device. In contrast, communication media may embody computer-readable instructions, data structures, program modules, or other data in a modulated data signal, such as a carrier wave, or other transport mechanism. As defined herein, computer storage media does not include communication media. Therefore, a computer storage medium should not be interpreted to be a propagating signal per se. Propagated signals may be present in a computer storage media, but propagated signals per se are not examples of computer storage media. Although the computer storage media is shown within the computing-based device, it will be appreciated that the storage may be distributed or located remotely and accessed via a network or other communication link, for example, by using a communication interface.

The methods described herein may be performed by software in machinereadable form on a tangible storage medium, e.g. in the form of a computer program comprising computer program code means adapted to perform all the steps of any of the methods described herein when the program is run on a computer and where the computer program may be embodied on a computer-readable medium. Examples of tangible storage media include computer storage devices comprising computer-readable media, such as disks, thumb drives, memory etc., and do not only include propagated signals. Propagated signals may be present in a tangible storage media, but propagated signals per se are not examples of tangible storage media. The software can be suitable for execution on a parallel processor or a serial processor such that the method steps may be carried out in any suitable order, or simultaneously.

Any range or device value given herein may be extended or altered without losing the effect sought.

Although at least a portion of the subject matter has been described in language specific to structural features and/or acts, it is to be understood that the subject matter defined in the appended claims is not necessarily limited to the specific features or acts described above. Rather, the specific features and acts described above are disclosed as examples of implementing the claims and other equivalent features and acts are intended to be within the scope of the claims.

It will be understood that the benefits and advantages described above may relate to one embodiment or may relate to several embodiments. The embodiments are not limited to those that solve any or all of the stated problems or those that have any or all of the stated benefits and advantages. It will further be understood that reference to 'an' item refers to one or more of those items.

The term 'comprising' is used herein to mean including the method blocks or elements identified, but that such blocks or elements do not comprise an exclusive list and a method or device may contain additional blocks or elements.

It will be understood that the above description is given by way of example only and that various modifications may be made by those skilled in the art. The above specification, examples and data provide a complete description of the structure and use of exemplary embodiments. Although various embodiments have been described above with a certain degree of particularity, or with reference to one or more individual embodiments, those skilled in the art could make numerous alterations to the disclosed embodiments without departing from the spirit or scope of this specification.

## Claims

1. A test device (10) for verifying a protective relay (20) operation at an electrical substation (100), wherein:
the protective relay (20) is configured to control a switching device (30) of an electrical grid (50) and to be connected to at least one low-power voltage sensor (LPVT) or to at least one low-power current sensor (LPCT); and
the test device (10) comprises:
a transceiver (13) for communicating with a remote computer (40); and
at least one processor (11) and a memory (12) storing instructions that, when executed, cause the test device (10) to:
measure at least one operating condition of the protective relay (20); and provide the operating condition to the remote computer (40),
**characterized in that**:
the test device (10) is configured to be connected between the protective relay (20) and the at least one low-power voltage sensor (LPVT) or the low-power current sensor (LPCT);
the test device (10) is configured to be connected between the protective relay (20) and the switching device (30);
the test device (10) is configured to operate on a direct current auxiliary power; and
in order to measure the operating condition, the processor (11) is configured to cause the test device (10) to:
disconnect the switching device (30) and the at least one low-power voltage sensor (LPVT) or low-power current sensor (LPCT) from the protective relay (20); and
generate a test signal to the protective relay (20); wherein
the remote computer (40) receives information of the operating condition in response to the test signal.

2. A test device (10) according to claim 1, **characterized by** comprising a first normally closed contact (14) for the connection between the protective relay (20) and the at least one low-power voltage sensor (LPVT) or the low-power current sensor (LPCT);
and a second normally closed contact (14) for the connection between the protective relay (20) and the switching device (30).

3. A test device (10) according to claim 1 or claim 2, **characterized by** being configured to interact with the remote computer conforming to a SCADA control system, wherein the test device (10) is connected to the remote computer via a remote terminal unit (RTU).

4. A test device (10) according to claim 3, **characterized in that** the test device (10) is configured to receive a contact signal from the remote terminal unit (RTU) and to start measuring the operating condition of the protective relay (20) in response to the contact signal.

5. A test device (10) according to any of the claims 1 to 4,
**characterized in that** the contact (14) for the low power current sensor (LPCT) is configured for a Rogowski coil sensor.

6. A test device (10) according to any of the claims 1 to 4,
**characterized in that** the contact (14) for the low power voltage sensor (LPVT) is configured to be selectively adapted for a Rogowski coil sensor.

7. A test device (10) according to any of the claims 1 to 6, **characterized by** being configured to run a predetermined sequence of test signals.

8. A test device (10) according to claim 7, **characterized by** being configured to:
detect the operating condition as a response to the test signal;
store into the memory (12) multiple detected operating conditions; and
detect a change in the operating conditions when compared to previously stored data.

9. A method for verifying, by a test device (10), a protective relay (20) operation at an electrical substation (100), wherein:
the protective relay (20) is controlling a switching device (30) of an electrical grid (50) and is connected to at least one low-power voltage sensor (LPVT) or to at least one low-power current sensor (LPCT);
the method comprising the steps of:
detecting at least one operating condition of the protective relay (20); and
providing the operating condition to a remote computer (40),
**characterized in that** the test device (10) is executing the steps of:
connecting between the protective relay (20) and a switching device (30) of the electrical grid (50);
connecting between the protective relay (20) and the at least one low-power voltage sensor (LPVT) or the low-power current sensor (LPCT);
operating on a direct current auxiliary power; and
in order to measure the operating condition:
disconnecting the switching device (30) and the at least one low-power voltage sensor (LPVT) or low-power current sensor (LPCT) from the protective relay (20);
generating a test signal to the protective relay (20); and
the remote computer receiving information of the operating condition of the protective relay (20) as a response to the test signal.

10. A method according to claim 9, **characterized by** interacting with the remote computer (40) according to a SCADA control system, wherein the test device (10) is connected to the remote computer via a remote terminal unit (RTU).

11. A method according to claim 10, **characterized by** the test device (10) receiving a contact signal from the remote terminal unit (RTU) and starting measuring the operating condition of the protective relay (20) in response to the contact signal.

12. A method according to any of the claims 9 to 11, **characterized by** the test device (10) connecting between the protective relay (20) and the at least one low-power voltage sensor (LPVT) or the low-power current sensor (LPCT) by a first normally closed contact (14); and connecting between the protective relay (20) and a switching device (30) of the electrical grid (50) by a second normally closed contact (14).

13. A method according to any of the claims 9 to 12, **characterized by** the test device (10) running a predetermined sequence of test signals; and storing into the memory (12) multiple measured operating conditions and detecting a change in the operating conditions when compared to previously stored data.

14. A Rogowski coil for an electrical substation (100) current sensor (LPCT), comprising a toroidal coil of wire (65) and a shield (60) surrounding the toroidal coil, **characterized in that** the shield comprises:
an electrically conductive mesh (60);
a first longitudinal edge (61) of the mesh (60) being connected to the outer perimeter of the toroidal coil (65), surrounding the outer perimeter,
wherein the overlapping portions of the first longitudinal edge (61) comprise insulation to prevent galvanic connection;
a second longitudinal edge (62) comprises multiple cuts, extending from the second longitudinal edge (62) towards the first longitudinal edge (61);
said multiple cuts forming multiple strips (63) being connected to the first longitudinal edge (61);
multiple strips (63) are wrapped around the toroidal coil (65), wherein the overlapping portions of the multiple strips (63) comprise insulation to prevent galvanic connection.

15. A Rogowski coil according to claim 14, **characterized in that** the electrically conductive mesh (60) comprises electrically conductive strands in diagonal angle towards the first longitudinal edge (61).
